# EUROPEAN PATENT SPECIFICATION

(11) **EP 0 342 107 B1**
(45) Date of publication and mention of the grant of the patent: **17.07.1996**
(21) Application number: 89401270.7
(22) Date of filing: 05.05.1989
(51) Int. Cl.: G06F 5/06

(54) **Flag for a FIFO**
Flagge für einen FIFO
Indicateur pour un tampon PEPS

(30) Priority: 09.05.1988 US 191555
(43) Date of publication of application: 15.11.1989
(73) Proprietor: SGS-THOMSON MICROELECTRONICS, INC. (a Delaware corp.), Carrollton, TX 75006 (US)
(72) Inventor: Kreifels, Gerard A., F-75116 Paris (FR)
(74) Representative: Driver, Virginia Rozanne

(56) References cited:
- US-A- 4 208 713
- US-A- 4 486 854
- US-A- 4 694 426

## Description

The present invention pertains in general to FIFOs and, more particularly, to the operation of the flags to determine the amount of information stored in the FIFO.

First In First Out Memories (FIFOs) provide an important data buffer function for reading and writing operations between two discrete machines of widely differing operating frequency. FIFOs allow asynchronous operation between the two machines, wherein data can be simultaneously written to the FIFO and read therefrom. The heart of the FIFO is a dual-port memory that enables the Read and Write operations to be independent of each other, this allowing truly asynchronous operation of the input and the output.

The dual-port memory portion of the FIFO can be realized with a dual-port RAM cell that has a plurality of addressable locations. The Read and Write pointers are provided for generating the addresses of the addressable locations for the Read and Write operations, respectively. The Read and Write pointers are incremented for a Read and Write operation, respectively, instead of actually moving the data through a series of shift registers. However, it is important that the Read pointer and Write pointer do not point to the same address at the same time wherein information would be written into a memory location and read from the same memory location simultaneously. To prevent this happening, status flags are utilized to provide an indication to the user of the proximity of the two pointers.

The status flags are utilized on the Read side to indicate to the user that the FIFO is empty. In this manner, the user would not attempt to read a FIFO that is empty and, in fact, circuitry is provided to inhibit incrementing of the Read pointer to overtake the Write pointer address. In a similar manner, a full flag is provided to indicate to the user that the memory is full, such that the user will not attempt to write data to the memory or increment the pointer past the Read pointer. The full and empty status flags are conventional flags that are provided in FIFOs.

An additional flag that has been provided for FIFOs in the past is a half-full flag that indicates to the Write side of the FIFO that the FIFO is half-full and to the Read side of the FIFO that the FIFO is half-empty. However, this type of flag has some synchronization problems associated therewith, especially when utilized with asynchronous operation. For example, when data is being written into the memory at a location that will set the half-full flag to the half-full position, it is important to insure that a simultaneous Read operation does not result in a flag error wherein the flag is in the wrong state. Typically, a FIFO having 2048 registers would have the half-full flag set when data is written into the 1025th location.

To solve the problem of half-full flag errors, various FIFOs have required the use of external circuitry to insure that the Read and Write operations do not occur within a predetermined time. This typically requires a blanking circuit of some type between the Read port and the Write port to insure that the Read and/or Write operation is delayed with respect to the other. However, the main disadvantage to this is that a truly asynchronous operation is defeated and the Read and Write ports must be synchronized.

US-A-4486854 describes a FIFO arrangement where empty, half-full and full flag circuitry is provided. The arrangement has a status flag generator which is arranged to provide the various flags. The arrangement also has status latches which holds the values appearing on the empty line, full line and half-full line whenever the data source sends a write or read signal is received until the entire write signal or a read operation is completed.

US-A-4208713 describes a FIFO circuit which is arranged to operate such that the size of buffer memory required is kept to a minimum. Due to the asynchronous operation of the two computers connected by the buffer memory, there is a risk that the memory may become either totally occupied or unoccupied. This risk is eliminated by a break generator. The break generator generates break signals which are sent to the first and second computers to inhibit information being sent to the buffer when it is full and from being drawn from the buffer when it is empty. The timing periods of the operating cycles have portions during which computer components work unreliably due to their reaction time. A reliability device compares the phases of the timing periods produced by clocks of the two computers to allow only break signals generated by the comparison of addresses in the parts of the period during which both counters are reliable.

US-A-4694426 describes a FIFO status circuit arranged to detect the full or empty status of a FIFO. The circuit has a flip-flop which receives a set input from a pulse generator providing pulses derived from write signals. Likewise the reset input of flip-flop is provided by a pulse generator which provides pulses derived from read signals. The Q and Q/ outputs are individually coupled to respective AND gates. Each gate is also driven by a FIFO equal signal which indicates that the read and write pointers are directed to the same address. This FIFO equal signal is stable before the pulses reach the flip-flop and thus serves to mask the metastable conditions which may arise in the flip-flop. The outputs of the flip-flop define whether the previous operation was a read or write operation and when combined with the FIFO equal signal by the AND gates defines whether the matching of the FIFO address pointers corresponds to a memory full or empty state.

According to one aspect of the present invention, there is provided a circuit for providing a flag for a FIFO, said flag being provided when the FIFO is filled to a predetermined extent, said circuitry comprising:
a Read pointer for determining the location in the FIFO for reading information therefrom and for being incremented for each Read operation in response to application of an external Read signal;
a Write pointer for determining the location in the FIFO for writing information thereto and for being incremented for each Write operation in response to application of an external Write signal; and
means for determining the proximity of said Read and Write pointers and operable to generate an output having one of first and second logic states, the second logic state representing a compare signal generated when said Read and Write pointers have a predetermined difference therebetween, said predetermined difference being representative that the FIFO has been filled to the predetermined extent,
characterised in that there is provided reset means responsive to the presence of said compare signal for generating a reset signal, and set means responsive to the output of said determining means changing from said second logic state to said first logic state to provide a set signal in response to the proximity of said Read and Write pointers changing as a result of application of an external Write signal,
in that said flag has a set condition and reset condition,
said flag being placed in the set condition in response to generation of said set signal and being placed in the reset condition in response to generation of said reset signal, and in that
blanking means are provided for inhibiting generation of said reset signal by said reset means for a predetermined duration of time after receipt of said external Read signal to prevent said reset signal from being generated proximate to the output of said determining means making a transition from said second logic state to said first logic state.

According to a second aspect of the present invention, there is provided a method for indicating that a FIFO is filled to a predetermined extent, comprising:
providing a Read pointer that determines the location in the FIFO for reading information therefrom, the Read pointer being incremented for each Read operation in response to receiving an external Read signal;
providing a Write pointer for determining the location in the FIFO for writing information thereto, the Write pointer being incremented for each Write operation in response to receiving an external Write signal; and
determining the difference between the Read and Write pointers and controlling a compare signal to make a change from a first logic state to a second logic state when the difference equals a predetermined proximity value representative that the FIFO is filled to said predetermined extent and for changing from the second logic state to the first logic state when the proximity changes from the predetermined proximity value,
characterized by the steps of
generating a reset signal in response to the compare signal being at the second logic state;
generating a set signal in response to the compare signal being at the second logic state when an external Write signal is received;
inhibiting generation of the reset signal for a predetermined duration of time after receipt of the external Read signal to prevent the reset signal from being generated when the compare signal makes a transition from the second logic state to the first logic state; and
placing a flag in a set condition when the set signal is generated and placing the flag in a reset condition in response to generation of the reset signal.

Embodiments of the present invention may provide an almost full flag for a FIFO.

A Read pointer may be provided for determining the location in the FIFO for reading information therefrom as well as a Write pointer for determining the location in the FIFO for writing information thereto. The Read pointer is incremented for each Read operation and the Write pointer is incremented for each Write operation with the Write pointer having a high value than the Read pointer. Counter circuitry may be provided for determining the proximity of the Read pointer to the Write pointer. When the Read and Write pointers are separated by a predetermined distance that is less that full and greater than empty, a compare signal may be generated at a second logic state. If the compare signal is not generated, the output of the counter circuitry is at a first logic state. When it is determined that the output of the counter circuitry is at a second logic state indicating the presence of the compare signal and the external write signal is received, a set signal is generated. A flag is then placed in a set position. When it is determined that the compare signal is next present, the flag is placed in a reset position.

Preferably the counter circuitry has a predetermined settling time after changing states from the first logic state to the second logic state or from the second logic state to the first logic state. Blanking circuitry is provided for inhibiting generation of the reset signal until a predetermined duration of time after generation of the external Read signal. The external Read signal causes the compare signal to change from the first logic state to the second logic state.

Preferably the counter circuitry has a predetermined settling time. The compare signal is latched onto one input of an AND circuit for a predetermined duration of time after receipt of the external Write signal. In addition, the other input of the AND gate is connected to a pulse having a width equal to the predetermined duration of time such that a set signal is generated only during that predetermined duration of time and is isolated from any change in the output of the counter circuit. Additionally, the reset operation is blanked during the predetermined duration of time.

For a more complete understanding of the present invention and the advantages thereof, reference is now made to the following description taken in conjunction with the accompanying Drawings in which:
Figure 1 illustrates a block diagram of the FIFO embodying the present invention;
Figure 2 illustrates a block diagram of the flag logic for generating the almost full flag;
Figure 3 illustrates a logic diagram of the counter;
Figure 4 illustrates a logic diagram of the pulse generation circuits for generating AEP and BEP;
Figure 5 illustrates a partial logic diagram of the flag logic;
Figure 6 illustrates the output circuitry of the flag logic for setting and resetting the flag;
Figure 7 illustrates a detailed logic diagram of the latch of Figure 5; and
Figures 8a-8j illustrate timing diagrams for the operation of the flag logic.

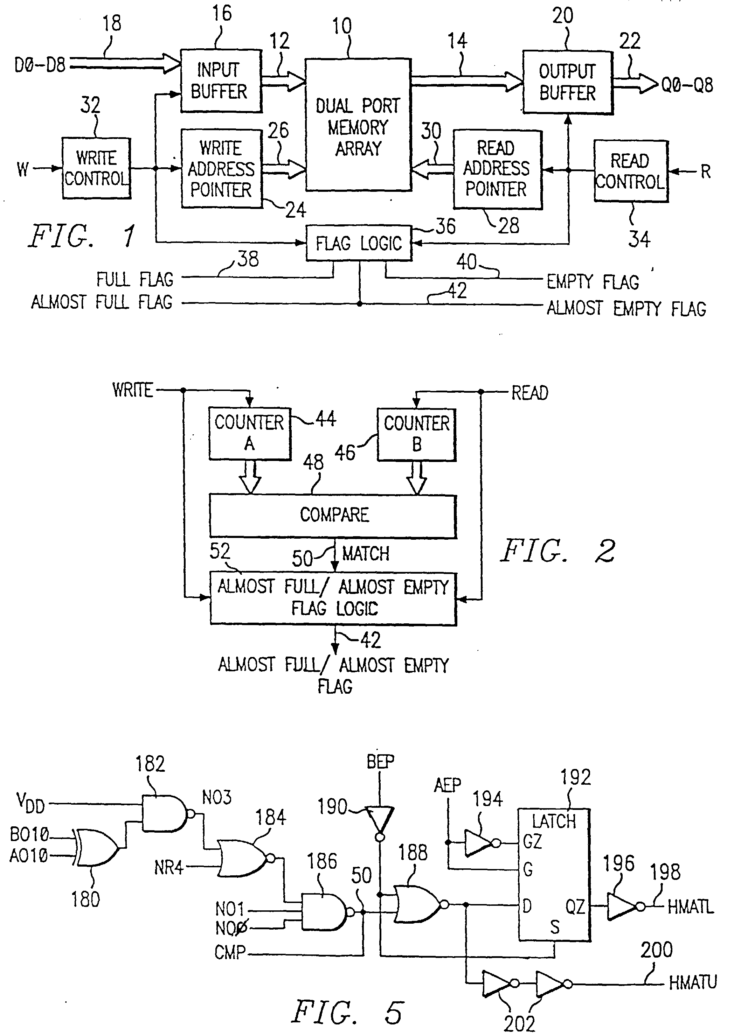

Referring now to Figure 1, there is illustrated a block diagram of the FIFO embodying the almost full/ almost empty flag of the present invention. The FIFO has a dual-port memory array 10 which has a data input port connected to a bus 12 and a data output port connected to a bus 14. The bus 12 is output from an input buffer 16 which is connected to input data D0̸-D8 on an input bus 18, and the bus 14 is input to an output buffer 20 which provides output data Q0̸-Q8 on an output bus 22. Although nine data bits are utilized, any number of data bits can be accomodated in accordance with the operation of the FIFO. The dual-port memory 10 is an array of addressable memory locations operable to be written to from the bus 12 and read out to the bus 14. However, it should be understood that any type of FIFO memory block, such as registers, etc., can be utilized in association with the present invention.

The memory array 10 has Write address input connected to a Write address pointer 24 through a bus 26. The Read address input is connected to the output of the Read address pointer 28 through a bus 30. The address pointers 24 and 28 are cyclical counters which are incremented by various control signals. The Write address pointer 24 is controlled by a Write control circuit 32 that is connected to a Write input signal and the Read address pointer 28 is controlled by a Read control circuit 34 that receives the Read input signal. By utilizing the cyclical counters, the next sequential address can be written to for each new data word input to the array 10 and the Read pointer 28 can be incremented to read out data stored at the next sequential address.

The output of the Write control circuit 32 is input to the input buffer 16, and also to a flag logic circuit 36, which also receives on an input thereof the output of the Read control circuit 34. The output of the Read Control circuit 34 is also input to the output buffer 20. The flag logic circuit 36 is operable to determine the proximity of the Write address pointer 24 and the Read address pointer 28 by internally counting each Write and Read operation and comparing the count values. A full flag is output on a line 38 when the Read pointer 28 and Write pointer 24 are at a maximum distance apart and an empty flag is output on a line 40 when the Read pointer 28 and the Write pointer 24 are equal. An almost full/almost empty flag is output on a line 42 to indicate a proximity in between empty and full. For purposes of the present invention, and by way of example only, this proximity is half-full. This flag is referred to as the half flag. The half flag is therefore set when one register representinq more than fifty percent of the addressable locations in the array 10 is written to, which flag indicates to the Write side that the array 10 is half-full. It should be understood that the half flag can be set and reset at any proximity of the two pointers such as, for example, four bytes from empty or eight bytes from full.

Referring now to Figure 2, there is illustrated a portion of the schematic block diagram of the flag logic circuit 36 including the portion thereof for generating the half flag on line 42. The generation of the full and empty flags on lines 38 and 40 is conventional and will not be described herein in detail. The output of the Write control circuit 32 is input to-a counter 44 and the output of the Read control 34 is input to a counter 46. Counter 44 and counter 46 are cyclical counters which are continually incremented. The output of counters 44 and 46 are input to a compare circuit 48. The compare circuit 48 generates a match on an output line 50 whenever the counters are separated by a value of 1024. This represents a half-full status wherein the array 10 in the preferred embodiment has a maximum register value of 2048. This match signal is input to an almost full flag logic block 52, the output of which provides the half flag on line 42. The flag logic circuit 52 also receives the output of the Write control circuit 32 and the output of Read control circuit 34, and is generally operable to set the flag when it is determined that the count value has gone from 1024 to 1025 and to reset the flag when it is determined that the count value is at 1024. In addition, the flag logic circuit 52 prevents errors from occurring in the status of the half flag when the Read and Write operations occur proximate to the transition between the values 1024 and 1025 and even when the transitions are simultaneous, such that an error in the half flag cannot occur.

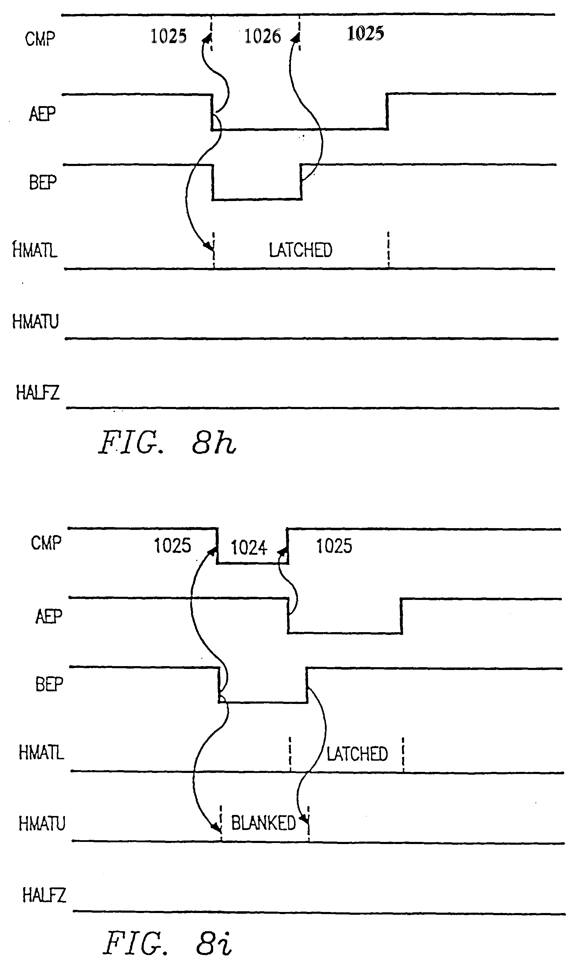

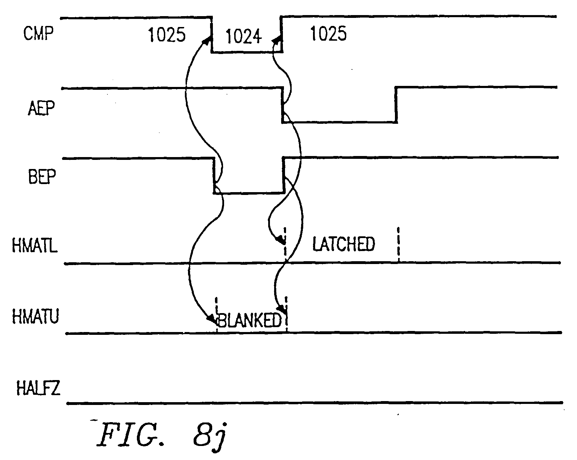

As will be described hereinbelow, the circuit generally operates by generating a narrow pulse off the trailing edge of the Read signal and a narrow pulse off an edge of the Write signal. By utilizing these narrow pulses, problems with setting and resetting the flag can only occur when the pulses overlap, thus reducing the possibility of errors to a significant extent. The operation of these narrow pulses and the setting and resetting of the value will be described in detail with regard to the timing diagrams of Figures 8a-8j.

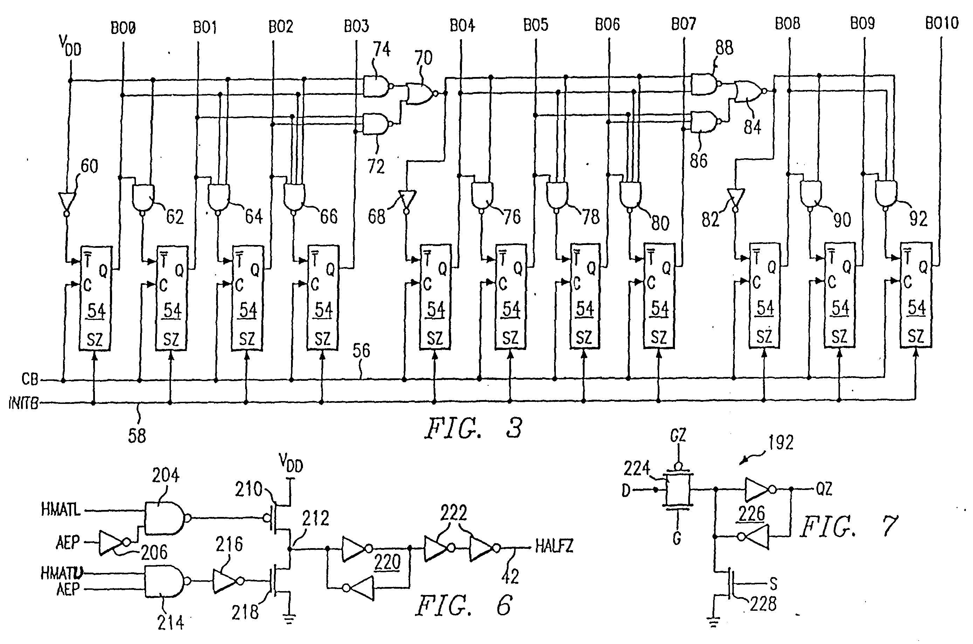

Referring now to Figure 3, there is illustrated a logic diagram of a cyclic eleven-bit counter which makes up each of counters 44 and 46, both counters being identical. Each of the eleven bits is comprised of a D-type flip flop 54 with each of the flip flops 54 having the Q-output thereof providing one of the output bits BO0̸-BO10̸. A second counter (not shown) would provide the values AO0̸ -AO10̸, this counter being identical to the counter illustrated in Figure 3.

The counter is clocked by a clock signal on line 56 and a set input is connected to a reset signal INITB on line 58. The counters are initially set to a predetermined value and then the counter clock incremented to the values BO0̸-BO10̸. The flip flop 54 associated with the bit BO0̸ has the data input thereof connected to V_{DD} through an invertor 60. The data input for the flip flop 54 associated with the BO1 bit has the input thereof connected to the output of a NAND gate 62, one input of which is connected to the BO0̸ bit and the other input of which is connected to V_{DD}. The data input for the BO2 flip flop 54 is connected to the output of a three-input NAND gate 64, one input of which is connected to the BO1 bit, one input of which is connected to the BO0̸ bit and one input of which is connected to the V_{DD}. The BO3 flip flop 54 has the data input thereof connected to the output of a four-input NAND gate 66, one input of which is connected to the BO2 bit, one input of which is connected to the BO1 bit, one input of which is connected to the BO0̸ bit and one input of which is connected to V_{DD}.

The data input to the BO4 flip flop 54 is connected through an invertor 68 to the output of a NOR gate 70. NOR gate 70 has one input thereof connected to the output of a three-input NAND gate 72 and the other input thereof connected to the output of a two-input NAND gate 74. NAND gate 72 has one input thereof connected to the BO3 bit, one input thereof connected to the BO2 bit and one input thereof connected to the BO1 bit. NAND gate 74 has one input thereof connected to the BO0̸ bit and one input thereof connected to V_{DD}.

The BO5 flip flop 54 has the data input thereof connected to the output of a NAND gate 76, one input of which is connected to the BO4 bit and one input of which is connected to the output of NOR gate 70. The BO6 flip flop 54 has the data input thereof connected to the output of a three-input NAND gate 78, one input of which is connected to the BO5 bit, one input of which is connected to the BO4 bit and one input of which is connected to the output of NOR gate 70. The BO7 flip flop 54 has the data input thereof connected to a four-input NAND gate 80, one input of which is connected to the BO6 bit, one input of which is connected to the BO5 bit, one input of which is connected to the BO4 input and one input of which is connected to the output of NOR gate 70.

The data input to the BO8 flip flop 54 is connected through an invertor 82 to the output of a NOR gate 84. NOR gate 84 has one input thereof connected to the output of a three-input NAND gate 86 and one input thereof connected to the output of two-input NAND gate 88. NAND gate 86 has one input thereof connected to the BO7 bit, one input thereof connected to the BO6 bit and one input thereof connected to the BO5 bit. NAND gate 88 has one input thereof connected to the BO4 bit and one input thereof connected to the output of NOR gate 70. The BO9 flip flop 54 has the data input thereof connected to the output of a NAND gate 90, one input of which is connected to the BO8 bit and one input of which is connected to the output of NOR gate 84. The B010̸ flip flop 54 has the data input thereof connected to the output of a three-input NAND gate 92, one input of which is connected to the BO9 bit, one input of which is connected to the BO8 bit and one input of which is connected to the output of NOR gate 84.

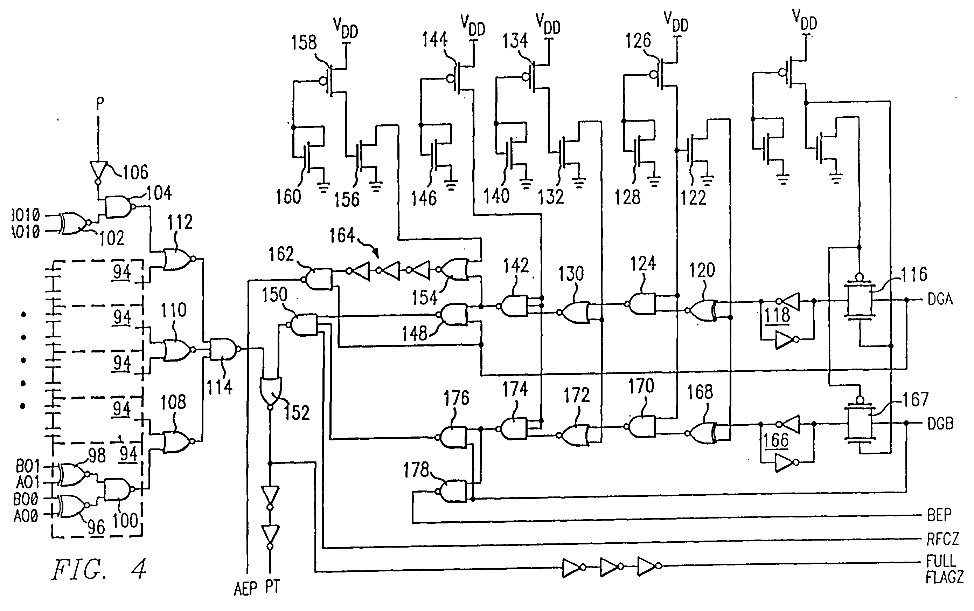

Referring now to Figure 4, there is illustrated a schematic digaram for generating low going pulses AEP and BEP for the flag logic 52 and also for generating the full flag. The compare operation for the flags is performed with logic NOR compare circuitry. The Exclusive NOR compare circuitry is comprised of a plurality of logic blocks 94. Each of the blocks 94 is comprised of two Exclusive NOR gates 96 and 98, the outputs of which are connected to the respective inputs of a two input NAND gate 100. The output of the NAND gate 100 provides the output from the block 94. Only the block 94 associated with counter bits AO0̸, BO0̸ and AO1, BO1 is illustrated in detail. For the illustrated block 94, the AO0̸, BO0̸ bits are input to respective inputs of Exclusive NOR gate 96 and the bits AO1 and BO1 are input to respective inputs of Exclusive NOR gate 98. The output thereof is labelled NA0̸. The blocks 94 are associated with bits AO0̸ and BO0̸ through AO9 and BO9, respectively. The bits AO10̸ and BO10̸ are input to a single Exclusive NOR gate 102, the output of which is input to one input of a NAND gate 104 to provide the output NA5. The other input of NAND gate 104 is connected through an invertor 106 to a signal P, which is low for normal operation.

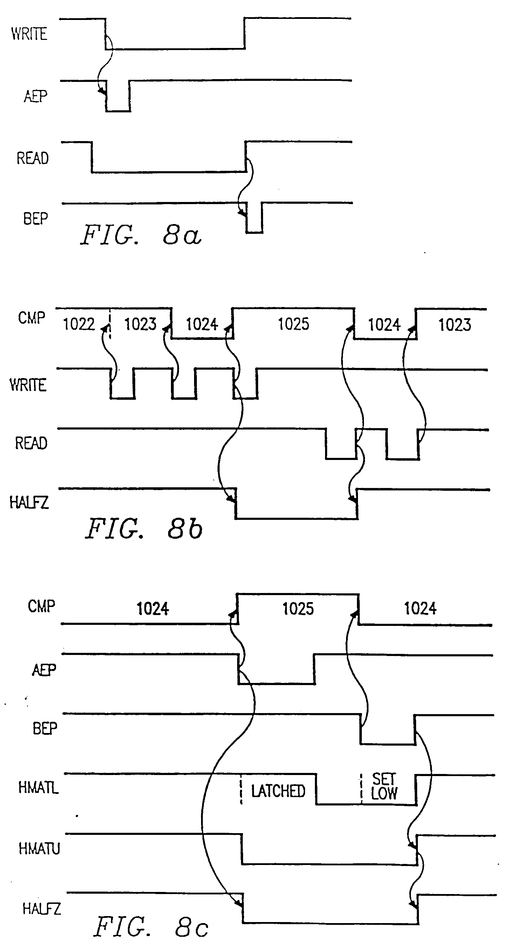

The outputs NA0̸ and NA1 are input to respective inputs of a NOR gate 108, the outputs NA2 and NA3 are input to respectiver inputs of a NOR gate 110 and the outputs NA4 and NA5 are input to respective inputs of a NOR gate 112. The outputs of NOR gates 108-112 provide the signals NO0̸, NO1 and NO2 respectively. These outputs are input to the respective inputs of a three-input NAND gate 114, the output of which provides the compare signal for the full flag logic. For purposes of the compare circuit 48 of Figure 2, select ones of the outputs NA0̸-NA5 and NO0̸-NO2 are utilized, as will be described with respect to Figure 5.

The Write control input is received on a terminal DGA and is a positive going pulse. The DGA pulse is input to a CMOS transfer gate 116 which is input to a latch 118 configured with back-to-back invertors. The delay of gate 116 and latch 118 matches the delay from the signal CB to generation of BO0̸ - BO10̸ in Figure 3 for input to the circuitry of Figure 5, described hereinbelow. The output of the latch 118 is connected to one input of an exclusive NOR gate 120, the other input of which is connected to ground through an N-channel transistor 122. The output of gate 120 is connected to one input of a NAND gate 124, the other input of which is connected to V_{DD} through a P-channel transistor 126. The gate of the P-channel transistor 126 is connected to ground through an N-channel load transistor 128.

The output of NAND gate 124 is connected to one input of a NOR gate 130, the other input thereof connected to ground through the source/drain path of an N-channel transistor 132. The gate of transistor 132 is connected to V_{DD} through the source/drain path of a P-channel transistor 134 which has the gate thereof connected to ground through an N-channel load transistor 140. The output of NOR gate 130 is connected to one input of a three-input NAND gate 142, the other input of which are connected to V_{DD} through the source/ drain path of a P-channel transistor 144, the gate of transistor 144 being connected to ground through a N-channel load transistor 146. The delay through gates 120, 124, 130 and 142 matches the delay through the compare circuit in each leg, for example, through gates 96, 100, 108 and 114 for one leg to generate CMP. The output of NAND gate 142 is connected to one input of a NAND gate 148, the other input of which is connected to the Write pulse DGA. The output of NAND gate 148 is connected to one input of a three input NAND gate 150, the output of which is connected to one input of a NOR gate 152. NOR gate 152 has the other input thereof connected to the output of NAND gate 114 to receive the compare output therefrom. The compare output of NAND gate 114 represents a comparison operation between the two counters with the output of NOR gate 152 providing the full flag indication. The operation of full flag will not be described in detail herein.

The output of NAND gate 142 is also input to one input of a NOR gate 154, the other input of which is connected to ground through an N-channel transistor 156, the gate of which is connected to V_{DD} through the P-channel transistor 158. The gate of P-channel transistor 158 is connected to ground through an N-channel load transistor 160. NOR gate 154 has the output thereof connected to one input of a NAND gate 162 through three series connected invertors 164. Invertors 164 and NOR gate 154 provide an important delay function that matches the delay in subsequent circuitry. The other input of NAND gate 162 is connected to the Write pulse DGA, the output of NAND gate 162 also providing the AEP pulse utilized in flag logic 52.

The Read input is a negative going pulse input on a terminal DGB. The DGB pulse is input to a latch 166 through a CMOS gate 167. The delay through gate 167 and latch 166 matches the delay from the signal CB to generation of BO0̸ - BO10̸ in Figure 3. The latch 166 has the output thereof connected to one input of an Exclusive NOR gate 168, the other input thereof connected to ground through N-channel transistor 122. The output of gate 168 is connected to one input of a NAND gate 170, the other input of which is connected to V_{DD} through transistor 126. The output of NAND gate 170 is connected to one input of a NOR gate 172, the other input of which is connected to ground through transistor 132. The output of gate 172 is connected to one input of a three-input NAND gate 174, the other two inputs of which are connected to V_{DD} through transistor 144. The delay through gates 168, 170, 172 and 174 matches the delay from BO0̸ - BO10̸ to generation of CMP.

The output of NAND gate 174 is connected to one input of a NAND gate 176, the other input of which is connected to the DGB pulse and the output of which is connected to one input of the NAND gate 150 to provide control signals for the full flag logic. The other input of NAND gate 150 is connected to an external signal RFCZ. In addition, the output of NAND gate 174 is connected to one input of a NAND gate 178, the other input of which is connected to the DGB pulse and the output- of which provides the BEP output for the flag logic 52. It should be noted that the circuitry for generation of the AEP and BEP signals is identical with the exception of the additional delay provided by the NOR gate 154 and the three invertors 164. The circuitry for generating AEP and BEP provides two separate one-shot operations with a duration equal to the delay provided through the respective chain of invertors. In addition, the Read signal DGB is generated off the trailing edge of the Read pulse since it is a negative going pulse at the input to the transfer gate 167.

Referring now to Figure 5, there is illustrated a logic diagram of one portion of the almost full flag logic 52. The bits BO10̸ and AO1∅ are input to respective inputs of an Exclusive OR gate 180, the output of which is connected to one input of a NAND gate 182. The other input of the NAND gate 182 is connected to V_{DD}. The output of NAND gate 182 is connected to one input of a NOR gate 184, the other input of which is connected to the counter output NA4 for output by the Exclusive OR block 94 in Figure 4. The output of NOR gate 184 is connected to one input of a three-input NAND gate 186, the other two inputs of which are connected to the signals NO1 and NO0̸ respectively, which are output by NOR gates 110 and 108, respectively, in the counter of Figure 4. The NAND gate 186 provides the compare signal CMP which is utilized by the flag logic 52.

The CMP signal is input to one input of a NOR gate 188, the other input of which is connected to the BEP signal through an invertor 190. The CMP signal is an active low such that when a match exists, CMP is low. The signals NO0̸, NO1 and NO3 are selected from the two counters 44 and 46 to provide a match when the difference between the two counters 44 and 46 is equal to 1024. This represents the half-full status. However, it should be understood that any value could be selected for operation of the flag logic 52 of Figure 2.

Since the CMP signal is active low, the output of NOR gate 188 will be a logic high when a match exists and BEP is high. When BEP is low or when there is no match, the output is a logic low. Therefore, the BEP signal provides a blanking operation during the BEP pulse, as will be described hereinbelow.

The output of NOR gate 188 is input to the data input of a latch 192. The clock input of the latch 192 is connected to the AEP signal and the clock-bar input thereof is connected to the AEP signal through an invertor 194. The set input thereof is connected to BEP and the Q-bar output thereof is connected through an invertor 196 to a terminal 198 to provide the HMATL signal. In addition, the output of NOR gate 188 is connected to a terminal 200 through two series connected invertors 202, to provide the HMATU signal. In operation of the circuit of Figure 5, it can be seen that the HMATU signal will be high only when the separation between the two pointers is 1024 and BEP is high. Whenever BEP goes low, HMATU goes low to provide a blanking function, or, whenever the difference between the pointers is anything but 1024, HMATU will be low.

The latch 192 is a transparent latch whenever AEP is high and, whenever AEP is low, the value on the input thereof is latched to the terminal 198. The set input thereof is connected to the output of the invertor 190 to set the value on terminal 198 to a logic low whenever the BEP pulse is generated. Therefore, if AEP goes low during BEP, the output on terminal 198 will be latched low. However, if BEP is high and the difference is 1024, a logic high will be latched onto terminal 198 during AEP.

Referring now to Figure 6, there is illustrated a logic diagram of the remaining portion of the flag logic 52 for interfacing with the logic circuitry of Figure 5. The HMATL signal is input to one input of a NAND gate 204, the other input of which is connected through an inverter 206 to AEP. The output of NAND gate 204 drives the gate of a P-channel transistor 210, the source of which is connected to V_{DD} and the drain of which is connected to an output node 212. The HMATU signal is connected to one input of a NAND gate 214, the other input of which is connected to AEP. The output of NAND gate 214 is connected through an invertor 216 to the gate of an N-channel transistor 218. N-channel transistor 218 has the drain thereof connected to node 212 and the source thereof connected to ground. Node 212 is connected to the input of a back-to-back invertor latch 220 which provides the almost empty/almost full flag labelled HALFZ on line 42 through two serially connected invertors 222.

The HMATL signal, in conjunction with the AEP signal, functions to set the half flag by pulling node 212 high through P-channel transistor 210. Therefore, when HMATL is high and AEP is low during the AEP pulse, the half flag is set. In addition, when setting the flag, AEP blanks operation of NAND gate 214 such that N-channel transistor 218 does not conduct. However, when HMATL is low and AEP is high, HMATU is operable to reset the flag. This only occurs when the CMP signal is low representing a difference value of 1024, and after BEP pulse has been generated at the trailing edge thereof.

Referring now to Figure 7, there is illustrated a schematic block diagram of the latch 192 of Figure 5. The latch 192 has the D-input thereof connected through a CMOS transfer gate 224 to the input of a back-to-back invertor type latch 226. The output of latch 226 provides the Q-bar output. The input of latch 226 is also connected to the drain of an N-channel transistor 228, the source of which is connected to ground and the gate of which is connected to the set input, which set input is also connected to BEP through invertor 190. The transfer gate 224 is controlled by the clock and clock-bar inputs such that when the clock input connected to AEP is high, transfer gate 224 conducts, and when AEP is low, transfer gate 224 is in a blocking state.

Referring now to Figures 8a-8j, there are illustrated timing diagrams showing various operations wherein a Write operation and a Read operation occur close in time during the period of setting or resetting the half flag for the almost empty/almost full status. With specific reference to Figure 8a, the Write input control signal is represented as a negative going pulse and the Read input control signal is also represented by a negative going pulse. The AEP pulse is a normally high signal which is triggered low in response to generation of the falling edge of the Write control signal width. This negative going pulse has a predetermined pulse width previously disclosed in Figure 4. Although the AEP negative going pulse is illustrated as occurring simultaneously with the edge of the Write pulse, it is actually delayed therefrom, as will be described hereinbelow. In a similar manner, the BEP signal is a normally high signal which has a negative going pulse generated off of the rising edge of the Read pulse and is delayed therefrom. The BEP negative going pulse has a pulse width that is less than the pulse width of the AEP pulse, as will be described hereinbelow.

With reference to Figure 8b, the CMP signal output by NAND gate 186 is normally high for all difference values of the two counters 44 and 46, except for the value 1024. When the difference value is 1024, the CMP signal is low. During normal operation where the difference value is less than 1024, the half flag HALFZ remains high, but the difference value is incremented for each Write operation. This difference value is the result of counter 44 being incremented and counter 46 not being incremented.

As illustrated by way of example in Figure 8b, the initial difference value is 1022 until the first Write operation, wherein the counter is incremented to a value of 1023 on the falling edge of Write. Upon the next Write operation, the difference value is incremented to 1024 and CMP goes low. At the next Write operation, representing a transition from 1024 to 1025, HALFZ goes low. HALFZ will remain low until a Read operation is performed. On the trailing edge of a Read pulse, the difference value is decremented from 1025 to 1024. This also results in CMP going low and HALFZ going high. Upon the next sequential Read operation with no Write operation, the difference value is again decremented to 1023 and the CMP signal goes high. This is a result of counter 46 being incremented without incrementing counter 44. Since the Write and Read operations give rise to the generation of the AEP and BEP pulses, respectively, further description of the timing operations will be described with reference only to the AEP and BEP pulses. However, the difference value and CMP are updated by the falling edge of a Write operation or the rising edge of a Read operation and not by AEP or BEP.

Figure 8c illustrates the case where CMP is initially set low as a result of a difference value of 1024 being present. This can be the result of either a Read operation resetting the half flag or a Write operation changing the difference value from 1023 to 1024. Figure 8c illustrates the case where a Write operation occurs before a Read operation and there is no overlapping.

When the Write operation occurs with CMP low, AEP goes low and raises CMP high as the difference changes from 1024 to 1025. This also results in the flag being set to a low indicating an almost full condition. The output signal HMATL is high as a result of the latch 192 latching the high output on NOR gate 188 to the HMATL terminal 198. The output of NOR gate 188 is high since the CMP signal was initially low and BEP was initially high. This value is latched to HMATL when AEP goes low. HMATU goes low when CMP goes high regardless of the state of BEP. BEP remains high during AEP and falls during a Read operation after AEP goes high. The falling edge of BEP coincides with the change in the difference value from 1025 to 1024, which causes CMP to go low. HMATL goes low when AEP goes high and while CMP is high, since latch 192 again becomes transparent. This value is maintained low during BEP, since the output of NOR gate 188 is low and the latch 192 is forced to a low logic state by BEP as a result of pulling down the input to the internal latch 226 in latch 192. At the end of BEP on the rising edge thereof, HMATU goes high, resulting in the flag HALFZ going high for a reset operation.

In operation, there are two functions that are achieved. The first is setting the flag and the second is resetting the flag. The operation of setting the flag is performed by determining that the count value has changed from 1024 to 1025. Therefore, some transition must be examined in order to determine this change. The decision is made by the fact that when AEP falls, it is known that the count value has been incremented since this coincides with the Write operation. Therefore, it is only necessary to know both that the previous count value was 1024 and that the falling edge of AEP has occurred. This would coincide with the count value being incremented to 1025. Therefore, the logic circuitry does not examine a change in CMP but, rather, it examines whether CMP was low, corresponding to a value of 1024, prior to AEP going low. Therefore, the set occurs on the falling edge of AEP.

In the set operation, it is important to insure that a reset does not inadvertently occur. The only way that the reset can occur is if for some reason the CMP signal went low for a very short duration of time. However, during AEP, the latch 192 is latched such that any change on the data input thereof is not reflected on the output thereof. This could occur as a result of the operation of the counters 44 and 46. During changes of states in the counter, some flip flops are slower than others, resulting in "glitches" which could inadvertently cause CMP to go low for a very short duration of time. Although illustrated as occurring simultaneously with the falling edge of AEP, the rising edge of CMP from the value of 1024 to 1025 occurs a short time after AEP goes low. Any potential glitches indicating a reset operation would occur around this falling edge. AEP prevents any operation related to CMP from being transferred through the circuitry to HMATL and, as such, AEP prevents these glitches from causing inadvertent resets. This is important when considering the occurrence of AEP when the count value is much less than 1024 wherein the half flag would not be set. If a glitch occurred in CMP which would appear as a transition from 1024 to 1025, the glitch would be blanked. The only condition that would result in a set operation is the existence of a low on the comparator output CMP or the occurrence of the low going edge of AEP. Therefore, the set operation is isolated from any glitches that occur as a result of the comparator operation and the operation of the counters. The decision is based solely upon the occurrence of the falling edge of AEP and the previous existence of the difference value 1024.

The operation for setting the flag is to be compared with the operation of resetting the flag. When resetting the flag, it is necessary to examine the transition of CMP to determine that it changed from a value of 1025 to a value of 1024. However, this transition is not examined until the end of BEP. At the end of BEP, any inadvertent glitches will have occurred and the counter settled to the correct value. For example, if the difference value varied from 1027 to 1026 during the Read operation, any glitches that would occur would occur around this transition. However, BEP blanks any potential reset operation until the rising edge thereof. This provides a predetermined amount of time for the counters to settle. Therefore, the reset operation is a function of the half-flag being set, the occurrence of the falling edge of CMP and the fact that the difference value corresponding to the CMP signal is equal to 1024 on the rising edge of BEP.

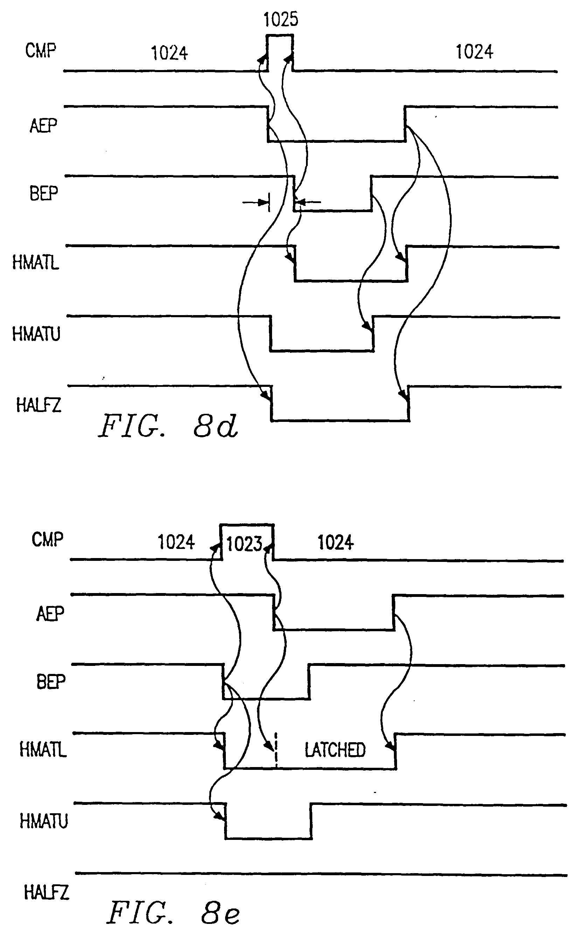

Figure 8d illustrates the case where the falling edge of AEP occurs just prior to the falling edge of BEP. When AEP goes low during a difference of 1024, CMP goes high since the difference is incremented to 1025. This also results in HMATL being latched in a high condition. The rising edge of CMP causes HMATU to go low and the falling edge of AEP causes HALFZ to go low. This effectively sets the flag. When the falling edge of BEP occurs, the difference value is decremented from 1025 to 1024, causing CMP to go low. The period in which CMP is high can be very short. However, HMATU remains low since BEP blanks HMATU and keeps it low until BEP goes back high on the rising edge thereof. This results in a logic high on the input to NAND gate 214. However, if the rising edge of BEP occurs before the rising edge of AEP, that is, the BEP pulse occurs totally within the AEP pulse, AEP blanks NAND gate 214 and prevents resetting of the flag. The flag is reset to a high on the rising edge of AEP allowing NAND gate 214 to go low on the output thereof and turn transistor 218 on. However, if the rising edge of BEP occurred after the rising edge of AEP, the flag would be reset on the rising edge of BEP. Therefore, the width of the AEP pulse provides a minimum time after setting of the half flag during which a reset cannot occur. This is due to the fact that a high logic state is latched on the HMATL output until BEP goes low, pulling the input of the latch 226 low. The time between the falling edge of AEP and the falling edge of BEP results in the half flag being set to a low logic state. The half flag cannot be reset until the rising edge of AEP, which edge occurs after the rising edge of BEP. In this condition, AEP controls the setting of the half flag with the later occurrence of BEP causing CMP to go low and the pulse width of AEP providing a minimum duration of time between setting and resetting of the half flag.

Figure 8e illustrates the case where the falling edge of BEP occurs just prior to the falling edge of AEP and the difference value is 1024. This indicates the situation where the flag is in a reset state and the difference value changes from 1024 to 1023. Therefore, at the falling edge of BEP, CMP goes high indicating a difference value of 1023. Simultaneously, HMATL goes low since BEP forces the output thereof to a low state. In addition, HMATU also goes low since, as described above, BEP provides a blanking function to present reset during the time that BEP is low.

When the falling edge of AEP occurs, the difference value is incremented from 1023 to 1024 and CMP goes low. In addition, the value on the input to the latch 192 is latched on the output thereof. In the example of Figure 8e, the falling edge of AEP occurs before the rising edge of BEP, and as such, HMATL is latched low. HMATL remains latched low until the rising edge of AEP. It is important to note that when the leading edge of AEP causes CMP to go low, HMATL is always latched to a low state, since that was the value output by the NOR gate 188 at the moment of latching. The only way that a set operation can occur is if the falling edge of AEP occurs when HMATL is a logic high. This must occur before the falling edge of BEP.

Figure 8f describes the case where the falling edges of AEP and BEP occur simultaneously, and the difference value prior to the occurrence of these falling edges is 1024. At the falling edge of AEP and the falling edge of BEP, the difference value will still be 1024. Therefore, CMP remains low both prior to and after the falling edges thereof. Since BEP goes low, the value of HMATL is forced to a low and this low state is latched in the latch 192. Further, HMATU is also forced to a low on the falling edge of BEP. Therefore, the flag stays in the reset state at a logic high. The only way that the flag could be set to a low state is if the falling edge of AEP occurred just prior to the falling edge of BEP and the high logic state was latched onto HMATL. However, if this did occur, the flag would be reset at the end of AEP, as illustrated in Figure 8d.

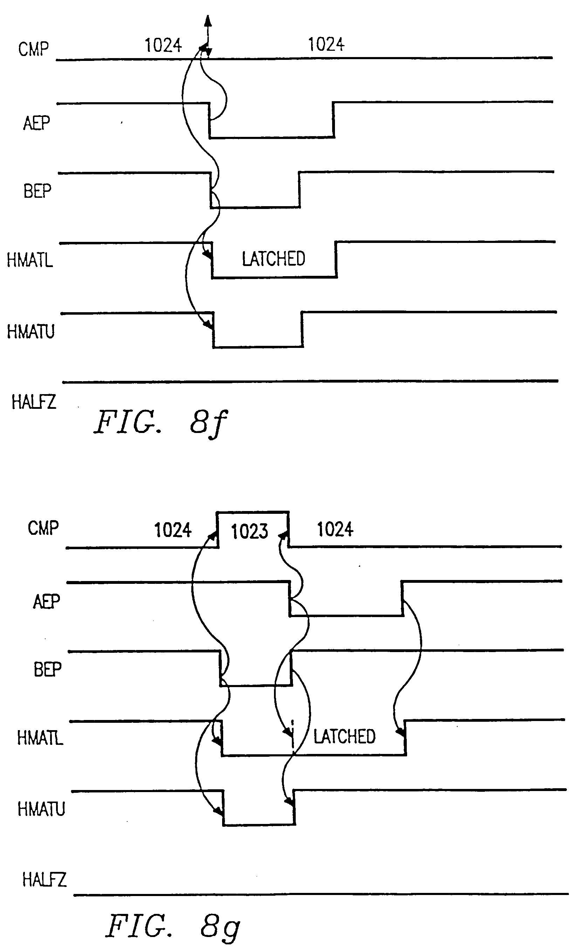

The timing diagram of Figure 8g illustrates the case where the falling edge of AEP occurs simultaneous with the rising edge of BEP, where the difference value was 1024 prior to the falling edge of BEP. When BEP goes low, the difference value changes to 1023 and CMP goes high. In addition, HMATL is forced low and HMATU is forced low. The falling edge of AEP causes CMP to go low, since the difference value is now 1024. The rising edge of BEP occurs concurrently, and the combination of CMP low and BEP high causes HMATU to go high. The falling edge of AEP also latches the low state previously on HMATL for the duration of AEP. HMATL goes high on the rising edge of AEP. Therefore, the flag is not set to a low logic state.

Figures 8h-8j illustrate the condition wherein the flag is initially set low indicating an almost full state and a Read and a Write operation occur in close proximity. Figure 8h illustrates the case where AEP occurs just prior to BEP. Initially, the difference value is 1025 and this difference value changes to 1026 on the falling edge of AEP. HMATL is low when the difference value is 1025 and this value is latched in latch 192 on the falling edge of AEP. When the falling edge of BEP occurs, the difference value changes to 1025 but CMP remains high. Therefore, nothing occurs to change the state of HMATL or HMATU which always remain low and, therefore, the half flag can never be reset. As described above, the half flag is reset after occurrence of the rising edge of AEP and if HMATU is high at that time. Since CMP never goes low, HMATU will always remain low. The only way for HMATU to go low is for the falling edge of BEP to occur just prior to the falling edge of AEP.

Figure 8i illustrates the case where the falling edge of BEP occurs just prior to the falling edge of AEP. When the falling edge of BEP occurs, the difference value changes from 1025 to 1024 and CMP goes low. However, during this time, HMATU is forced low since BEP goes low, which, as described above, is a portion of the blanking function of the BEP pulse. When the falling edge of AEP occurs, the difference value changes from 1024 to 1025 and HMATL is latched to a low condition. The reason that HMATL is latched to a low condition is that BEP forced HMATL to a low during the time in which BEP is low. Since the falling edge of AEP occurs before the rising edge of BEP, the half flag cannot be reset. This would require CMP to be low after the rising edge of BEP. However, if the falling edge of AEP occurred after the rising edge of BEP, the half flag would be reset to a high, but the subsequent rising edge of AEP would set the half flag back to a low state. In this case, HMATU would go high at the rising edge of BEP and then a logic high would be latched onto HMATL during AEP.

Figure 8j illustrates the case where the falling edge of AEP occurs simultaneous with the rising edge of BEP when the half flag is set low, indicating an almost full condition. In this state, the falling edge of BEP changes the difference value from 1025 to 1024 and CMP goes low. In addition, HMATU is forced to a low as a result of the blanking function of BEP until the rising edge thereof. HMATL is forced low from the falling edge of BEP until the rising edge thereof. This results in AEP latching the low state onto HMATL on the rising edge thereof, which also causes CMP to go high and also prevents resetting of the flags since the flag cannot be reset during AEP. If the falling edge of AEP occurred just after the rising edge of BEP, HMATU would go high and reset the flag. However, as soon as the rising edge of AEP occurred, a logic high would be latched into HMATL and the flag would be reset. It is important for this operation that both HMATU be low and that AEP blank the reset function.

From the above operation, it can be seen that the setting/resetting of the flag occurs when a difference value between the pointers changes from a first predetermined value to the next and second predetermined value. This can be an increase in value or a decrease in value. The flag is set when it is determined that there has been an increase from the first value, and the flag is reset when it is determined that there has been a decrease to the first value. An increase in value from the initial value is determined by first making the decision that the first value is present and then making a determination that there has been an increase. This is done with the use of AEP where AEP in and of itself indicates an increase in value and the only information that is required to set the flag is whether the first value was present prior to the occurrence of the leading edge of AEP. During setting of the flag, it is important to blank out circuit operations so that no internal circuit glitches occur. Therefore, AEP blanks out any possible reset operation and any glitches due to the operation of the comparator. Since a comparator transition could occur every time AEP is generated or every time a Write operation occurs, AEP provides this blanking function every time the difference value is incremented. On the other hand, the reset operation occurs whenever there is a decrease in the difference value from the second value to the first value and this decision is made in that a reset operation occurs by the mere existence of the first value. Of course, the first value, which in the preferred embodiment is 1024, is present for a much longer duration of time, i.e. 50 nanoseconds, as compared to the amount of time required to make a decision for a reset operation. The reset operation does provide a blanking operation that both stops any reset operation that was previously occurring and also provides a predetermined amount of delay to insure that the counters and the comparator have settled before making this decision.

The blanking function of BEP in the circuit of Figure 6 illustrates the timing relationship between the reset and set operations. In the set operation, AEP blanks any possible occurrence of reset to determine if HMATL is high. For example, during this period, any operation with respect to the comparator and BEP is blanked to prevent a potential high-going glitch from turning on transistor 218. For this purpose, AEP has a pulse width that is slightly longer than BEP. This is such that the pulse width of AEP corresponds to the duration of time that HMATU would be blanked by BEP. Since this blanking operation has three invertors 190, 202 and a NOR gate 188 introduced into the chain and AEP is input directly to NAND gate 214, the NOR gate 154 and three invertors 164 compensate for this delay. However, it is important to insure that the reset operation is blanked for the full duration of AEP and that HMATU does not cause a reset operation to occur. In a similar manner, BEP is operable to blank the reset operation by blanking HMATU during BEP and also to stop any ongoing reset operation.

Although the preferred embodiment has been described in detail, it should be understood that various changes, substitutions and alterations can be made therein without departing from the scope of the invention as defined by the appended claims.

## Claims

1. A circuit for providing a flag (HALFZ) for a FIFO (10), said flag being provided when the FIFO is filled to a predetermined extent, said circuitry comprising:
a Read pointer (28) for determining the location in the FIFO for reading information therefrom and for being incremented for each Read operation in response to application of an external Read signal;
a Write pointer (24) for determining the location in the FIFO for writing information thereto and for being incremented for each Write operation in response to application of an external Write signal; and
means (44, 46, 48) for determining the proximity of said Read and Write pointers (24, 28) and operable to generate an output having one of first and second logic states, the second logic state representing a compare signal generated when said Read and Write pointers have a predetermined difference therebetween, said predetermined difference being representative that the FIFO has been filled to the predetermined extent,
characterised in that there is provided reset means (214) responsive to the presence of said compare signal for generating a reset signal, and set means (192, 204) responsive to the output of said determining means changing (44, 46, 48) from said second logic state to said first logic state to provide a set signal in response to the proximity of said Read and Write pointers changing as a result of application of an external Write signal,
in that said flag has a set condition and reset condition, said flag being placed in the set condition in response to generation of said set signal and being placed in the reset condition in response to generation of said reset signal, and in that
blanking means (AEP, 214) are provided for inhibiting generation of said reset signal by said reset means for a predetermined duration of time after receipt of said external Read signal to prevent said reset signal from being generated proximate to the output of said determining means making a transition from said second logic state to said first logic state.

2. The circuit as claimed in claim 1, wherein said flag is provided when said FIFO is almost full.

3. The circuit as claimed in claim 1 or 2, wherein said determining means comprises counter means (44, 46).

4. The circuit of claim 3, wherein said counter means (44, 46) has a predetermined settling time when making a transition from said first logic state to said second logic state, and from said second logic state to said first logic state and said blanking means comprises:
first blanking means (188, BEP) for preventing generation of said set signal for a predetermined duration of time after receipt of said external Write signal to allow said counter means to settle such that said predetermined duration of time is longer than said settling time; and
second blanking means (AEP, 214) for preventing the generation of said reset signal for a second predetermined duration of time after receipt of said external Read signal to allow said counter means to settle, said second predetermined duration of time being longer than said predetermined settling time.

5. The circuit of any of claims 1 to 4, wherein said set means comprises means (204) for determining if said compare signal is present when said external Write signal is received and generating said set signal in response thereto, such that said set signal is generated independently of said determining means (44, 46) having the output changed from said second logic state to said first logic state.

6. The circuit of any preceding claim, wherein said determining means comprises:
a first counter (46) for being incremented in response to receipt of said external Read signal and having a first count value corresponding to the value of said Read pointer;
a second counter (44) for being incremented in response to receipt of said external Write signal and having a second count value corresponding to the value of said Write pointer such that the difference in the value of said first and second count values corresponds to the proximity of said Read and Write pointers, and
a compare circuit (48) for comparing said first value with the second value and outputting a compare signal at said second logic state when said first and second count values have said predetermined difference therebetween.

7. The circuit as claimed in any preceding claim, wherein said set means comprises:
a latch (192) having a data input (D) connected to the output of said determining means and operable to latch the logic state on the output of said determining means to the output (QZ) of said latch (192) in response to receipt of said external Write signal;
an AND gate (204) having first and second inputs and an output and operable to perform an AND logic function; and
pulse generation means (116, 118, 120, 124, 130, 142, 164, 162) for generating a Write pulse (AEP) having a pulse width of a predetermined duration of time and generated in response to receipt of said external Write signal, said Write pulse input to one input of said AND gate (204) and said Write pulse operable to control said latch (192) to latch the logic state on the output of said determining means to the other input of said AND gate,
the output of said AND gate (204) comprising said set signal which is generated only during the pulse width of said Write pulse and in response to the output of said determining means being at the second logic state at the beginning of said Write pulse.

8. The circuit of claim 7, wherein generation of said reset signal is inhibited during said Write pulse.

9. The circuit of claim 7 or 8, wherein said blanking means inhibits generation of said reset signal during said predetermined duration of time.

10. The circuit of claim 6 or any claim appended thereto, wherein said compare circuitry (48) and said first and second counters (44, 46) have a predetermined settling time in making a transition between said first and second logic states and wherein said predetermined duration of time of said blanking means exceeds said settling time.

11. A method for indicating that a FIFO (10) is filled to a predetermined extent, comprising:
providing a Read pointer (28) that determines the location in the FIFO for reading information therefrom, the Read pointer being incremented for each Read operation in response to receiving an external Read signal;
providing a Write pointer (26) for determining the location in the FIFO for writing information thereto, the Write pointer being incremented for each Write operation in response to receiving an external Write signal; and
determining the difference between the Read and Write pointers and controlling a compare signal to make a change from a first logic state to a second logic state when the difference equals a predetermined proximity value representative that the FIFO is filled to said predetermined extent and for changing from the second logic state to the first logic state when the proximity changes from the predetermined proximity value,
characterized by the steps of
generating a reset signal in response to the compare signal being at the second logic state;
generating a set signal in response to the compare signal being at the second logic state when an external Write signal is received;
inhibiting generation of the reset signal for a predetermined duration of time after receipt of the external Read signal to prevent the reset signal from being generated when the compare signal makes a transition from the second logic state to the first logic state; and
placing a flag (HALFZ) in a set condition when the set signal is generated and placing the flag in a reset condition in response to generation of the reset signal.

12. The method of claim 11, wherein the step of determining the proximity value comprises:
incrementing a first counter (46) in response to receipt of the external Read signal, the first counter having a first count value corresponding to the value of the Read pointer;
incrementing a second counter (44) in response to receipt of the external Write signal, the second counter having a second count value corresponding to the value of the Write pointer; and
comparing the first and second count values and outputting the compare signal at the second logic state when the proximity of the Read and Write pointers is equal to the predetermined proximity value.

## Patentansprüche

1. Schaltung zum Bereitstellen eines Flags bzw. Zustandsbits (HALFZ) für einen FIFO-Speicher (10), wobei das Flag bzw. Zustandsbit zur Verfügung gestellt wird, wenn der FIFO-Speicher bis zu einem vorbestimmten Ausmaße gefüllt ist, wobei die Schaltung aufweist:
einen Lesezeiger (28), um den Platz in dem FIFO-Speicher zu bestimmen, um Informationen daraus zu lesen, und um für jede Leseoperation in Reaktion auf das Anlegen eines externen Lesesignals inkrementiert bzw. hochgezählt zu werden;
einen Schreibzeiger (24), um den Platz in dem FIFO-Speicher zu bestimmen, um in diesen Informationen zu schreiben, und um für jede Schreiboperation in Reaktion auf das Anlegen eines externen Schreibsignals inkrementiert bzw. hochgezählt zu werden; und
Mittel (44, 46, 48), um die Annäherung der Lese- und Schreibzeiger (24, 28) zu bestimmen, und die betreibbar sind, um einen Ausgang zu erzeugen, der einen eines ersten und eines zweiten logischen Zustandes aufweist, wobei der zweite logische Zustand ein Vergleichssignal darstellt, das erzeugt wird, wenn die Lese- und Schreibzeiger einen vorbestimmten Unterschied zueinander aufweisen, wobei der vorbestimmte Unterschied darstellt, daß der FIFO-Speicher bis zu dem vorbestimmten Ausmaß gefüllt worden ist,
dadurch gekennzeichnet, daß
eine Rücksetzeinrichtung (214), die auf das Anlegen des Vergleichssignals anspricht, um ein Rücksetzsignal zu erzeugen, und
Einstellmittel (192, 204) vorgesehen sind, die auf den Ausgang der Bestimmungsmittel (44, 46, 48) ansprechen, der von dem zweiten logischen Zustand zu dem ersten logischen Zustand wechselt, um ein Einstellsignal in Reaktion auf die Annäherung an die Lese- und Schreibzeiger zur Verfügung zu stellen, die sich als ein Ergebnis des Anlegens eines externen Schreibsignals ändern,
daß das Flag bzw. Zustandsbit eine Einstellbedingung und eine Rücksetzbedingung hat, wobei das Flag bzw. Zustandsbit in die Einstellbedingung in Reaktion auf die Erzeugung des Einstellsignals versetzt wird, und in Reaktion auf die Erzeugung des Rücksetzsignals in die Rücksetzbedingung versetzt wird, und
daß Unterdrückungsmittel (AEP, 214) vorgesehen sind, um die Erzeugung des Rücksetzsignals durch die Rücksetzeinrichtung über eine vorbestimmte Zeitdauer nach dem Empfang des externen Lesesignals zu sperren, um das Rücksetzsignal davon abzuhalten, angenähert an den Ausgang der Bestimmungsmittel erzeugt zu werden, die einen Übergang von dem zweiten logischen Zustand zu dem ersten logischen Zustand machen.

2. Schaltung nach Anspruch 1, in der das Flag bzw. das Zustandsbit zur Verfügung gestellt wird, wenn der FIFO-Speicher nahezu voll ist.

3. Schaltung nach einem der Ansprüche 1 oder 2, in der die Bestimmungsmittel Zählmittel (44, 46) aufweisen.

4. Schaltung nach Anspruch 3, in der das Zählmittel (44, 46) eine vorbestimmte Einstellzeit hat, wenn es einen Übergang von dem ersten logischen Zustand zu dem zweiten logischen Zustand, und von dem zweiten logischen Zustand zu dem ersten logischen Zustand macht, wobei die Unterdrückungsmittel aufweisen:
erste Unterdrückungsmittel (188, BEP), um die Erzeugung des Einstellsignals über eine vorbestimmte Zeitdauer nach dem Empfang des externen Schreibsignals zu verhindern, um es den Zählmitteln zu ermöglichen, sich so einzustellen, daß die vorbestimmte Zeitdauer länger ist als die Einstellzeit; und
zweite Unterdrückungsmittel (AEP, 214), um die Erzeugung des Rücksetzsignals über eine zweite vorbestimmte Zeitdauer nach dem Empfang des externen Lesesignals zu verhindern, um es den Zählmitteln zu ermöglichen, sich einzustellen, wobei die zweite vorbestimmte Zeitdauer länger ist als die vorbestimmte Einstellzeit.

5. Schaltung nach einem der Ansprüche 1 bis 4, in der das Einstellmittel Mittel (204) aufweist, um festzulegen, ob das Vergleichssignal angelegt wird, wenn das externe Schreibsignal empfangen wird und das Einstellsignal in Reaktion darauf zu erzeugen, so daß das Einstellsignal unabhängig von den Bestimmungsmitteln (44, 46) erzeugt wird, die den Ausgang von dem zweiten logischen Zustand zu dem ersten logischen Zustand geändert haben.

6. Schaltung nach einem der voranstehenden Ansprüche, in der die Bestimmungsmittel aufweisen:
eine erste Zähleinrichtung (46), um in Reaktion auf den Empfang des externen Lesesignals inkrementiert bzw. hochgezählt zu werden, und einen ersten Zählwert hat, der dem Wert des Lesezeigers entspricht;
eine zweite Zähleinrichtung (44), um in Reaktion auf dem Empfang des externen Schreibsignals inkrementiert bzw. hochgezählt zu werden, und einen zweiten Zählwert aufweist, der dem Wert des Schreibzeigers entspricht, so daß der Unterschied in dem Wert des ersten und des zweiten Zählwertes der Näherung bzw. Annäherung der Lese- und Schreibzeiger entspricht, und
eine Vergleichsschaltung (48), um den ersten Wert mit dem zweiten Wert zu vergleichen, und ein Vergleichssignal bei dem zweiten logischen Zustand auszugeben, wenn der erste und der zweite Zählwert zwischeneinander den vorbestimmten Unterschied haben.

7. Schaltung nach einem der voranstehenden Ansprüche, in der die Einstellmittel aufweisen:
einen Zwischen- bzw. Haltespeicher (192), der einen Dateneingang (D) hat, der an den Ausgang der Bestimmungsmittel angeschlossen ist, und betreibbar ist, um den logischen Zustand an dem Ausgang der Bestimmungsmittel zu dem Ausgang (QZ) des Zwischen- bzw. Haltespeichers (192) in Reaktion auf den Empfang des externen Schreibsignals zu halten bzw. zwischenzuspeichern;
ein UND- bzw. AND-Gatter (204), das einen ersten und einen zweiten Eingang und einen Ausgang aufweist, und betreibbar ist, um eine logische UND- bzw. AND-Funktion durchzuführen; und
Puls- bzw. Takterzeugungsmittel (116, 118, 120, 124, 130, 142, 164, 162), um einen Schreibimpuls bzw. -takt zu erzeugen, der eine Impuls- bzw. Taktbreite einer vorbestimmten Zeitdauer hat und in Reaktion auf den Empfang des externen Schreibsignals erzeugt wird, wobei der Schreibpuls bzw. -takt in einen Eingang des AND- bzw. UND-Gatters (204) eingegeben wird, und der Schreibpuls bzw. -takt betreibbar ist, um den Zwischen- bzw. Haltespeicher (192) zu steuern, um den logischen Zustand an dem Ausgang der Bestimmungsmittel an dem anderen Eingang des UND- bzw. AND-Gatters zu halten bzw. zwischenzuspeichern,
wobei der Ausgang des AND- bzw. UND-Gatters (204) das Einstellsignal aufweist, das nur während der Puls- bzw. Taktbreite des Schreibimpulses bzw. Schreibtaktes und in Reaktion auf den Ausgang der Bestimmungsmittel erzeugt wird, der bei dem Beginn des Schreibtaktes bzw. Schreibimpulses in dem zweiten logischen Zustand ist.

8. Schaltung nach Anspruch 7, in der die Erzeugung des Rücksetzsignals während des Schreibpulses bzw. Schreibtaktes gesperrt ist.

9. Schaltung nach einem der Ansprüche 7 oder 8, in der die Unterdrückungsmittel die Erzeugung des Rücksetzsignals während der vorbestimmten Zeitdauer sperren.

10. Schaltung nach Anspruch 6 oder einem darauf zurückbezogenen Anspruch, in der die Vergleichsschaltung (48) und die erste und die zweite Zähleinrichtung (44, 46) eine vorbestimmte Einstellzeit beim Durchlaufen eines Übergangs zwischen dem ersten und dem zweiten logischen Zustand haben, und in der die vorbestimmte Zeitdauer der Unterdrückungsmittel die Einstellzeit überschreitet.

11. Verfahren um Anzuzeigen, das ein FIFO-Speicher (10) bis zu einem vorbestimmten Ausmaß gefüllt ist, das aufweist:
ein Lesezeiger (28) wird zur Verfügung gestellt, der den Platz in dem FIFO-Speicher bestimmt, um daraus Informationen zu lesen, wobei der Lesezeiger für jede Leseoperation in Reaktion auf den Empfang eines externen Lesesignals inkrementiert bzw. hochgezählt wird;
ein Schreibzeiger (26) wird zur Verfügung gestellt, um den Platz in dem FIFO-Speicher zu bestimmen, um in diesen Informationen zu schreiben, wobei der Lesezeiger für jede Schreiboperation in Reaktion auf den Empfang eines externen Schreibsignals inkrementiert bzw. hochgezählt wird; und
der Unterschied zwischen dem Lese- und dem Schreibzeiger wird bestimmt, und ein Vergleichssignal wird gesteuert, um eine Änderung von einem ersten logischen Zustand zu einem zweiten logischen Zustand zu machen, wenn der Unterschied einem vorbestimmten angenäherten Wert gleicht, der dafür steht, daß der FIFO-Speicher bis zu einem vorbestimmten Ausmaß gefüllt ist, und um von dem zweiten logischen Zustand zu dem ersten logischen Zustand zu wechseln, wenn die Annäherung von dem vorbestimmten Annäherungswert abweicht bzw. sich ändert,
gekennzeichnet durch die folgenden Schritte:
ein Rücksetzsignal wird in Reaktion auf das Vergleichssignal erzeugt, das bei dem zweiten logischen Zustand ist,
ein Einstellsignal wird in Reaktion auf das Vergleichssignal erzeugt, das bei dem ersten logischen Zustand ist, wenn ein externes Schreibsignal empfangen wird;
die Erzeugung des Rücksetzsignals wird über eine vorbestimmte Zeitdauer nach dem Empfang des externen Lesesignals gesperrt, um das Rücksetzsignal davon abzuhalten, erzeugt zu werden, wenn das Vergleichssignal einen Übergang von dem zweiten logischen Zustand zu dem ersten logischen Zustand macht; und
ein Flag bzw. Zustandsbit (HALFZ) wird in eine Einstellbedingung gebracht, wenn das Einstellsignal erzeugt ist, und das Flag bzw. Zustandsbit wird in Reaktion auf die Erzeugung des Rücksetzsignals in eine Rücksetzbedingung versetzt.

12. Verfahren nach Anspruch 11, in dem der Schritt des Bestimmens des Näherungswertes aufweist:
eine erste Zähleinrichtung (46) wird in Reaktion auf den Empfang des externen Lesesignals inkrementiert bzw. hochgezählt, wobei die erste Zähleinrichtung einen ersten Zählwert hat, der dem Wert des Lesezeigers entspricht;
eine zweite Zähleinrichtung (44) wird in Reaktion auf den Empfang des externen Schreibsignals inkrementiert bzw. hochgezählt, wobei die zweite Zähleinrichtung einen zweiten Zählwert hat, der dem Wert des Schreibzeigers entspricht; und
der erste und der zweite Zählwert werden verglichen und das Vergleichssignal wird bei einem zweiten logischen Zustand ausgegeben, wenn die Annäherung des Lese- und des Schreibzählers dem vorbestimmten Näherungswert gleicht.

## Revendications

1. Circuit pour fournir un indicateur (HALFZ) pour une mémoire de type premier entré-premier sorti (10), ledit indicateur étant fourni lorsque la mémoire de type premier entré-premier sorti est remplie jusqu'à un niveau prédéterminé, ledit circuit comprenant :
un pointeur de Lecture (28) pour déterminer un emplacement dans la mémoire de type premier entré-premier sorti afin d'y lire des informations et destiné à être incrémenté à chaque opération de Lecture répondant à l'application d'un signal de Lecture externe ;
un pointeur d'Ecriture (24) pour déterminer un emplacement dans la mémoire de type premier entré-premier sorti afin d'y écrire des informations et destiné à être incrémenté à chaque opération d'Ecriture répondant à l'application d'un signal d'Ecriture externe ; et
des moyens (44, 46, 48) pour déterminer la proximité desdits pointeurs de Lecture et d'Ecriture (24, 28) et qui sont fonctionnels pour produire une sortie ayant un premier et un second états logiques, le second état logique représentant un signal de comparaison produit lorsque lesdits pointeurs de Lecture et d'Ecriture ont entre eux une différence prédéterminée, ladite différence prédéterminée étant représentative de ce que la mémoire de type premier entré-premier sorti a été remplie jusqu'au niveau prédéterminé,
caractérisé en ce qu'il comporte des moyens de remise à zéro (214), sensibles à la présence dudit signal de comparaison pour produire un signal de remise à zéro et
des moyens de mise à un (192, 204) en répondant à la sortie desdits moyens de détermination (44, 46, 48) passant dudit second état logique audit premier état logique pour délivrer un signal de mise à un en réponse à la proximité desdits pointeurs de Lecture et d'Ecriture qui change suite à l'application d'un signal d'Ecriture externe,
en ce que ledit indicateur a une condition de mise à un et une condition de remise à zéro, ledit indicateur étant placé dans la condition de mise à un en réponse à la production dudit signal de mise à un et étant placé dans la condition de remise à zéro en réponse à la production dudit signal de remise à zéro, et en ce que
des moyens de blocage (AEP, 214) sont fournis pour interdire la production dudit signal de remise à zéro par lesdits moyens de remise à zéro pendant une durée prédéterminée après la réception dudit signal de Lecture externe pour empêcher ledit signal de remise à zéro d'être produit à proximité d'une transition dudit second état logique audit premier état logique effectué par la sortie desdits moyens de détermination.

2. Circuit selon la revendication 1, dans lequel ledit indicateur est fourni lorsque ladite mémoire de type premier entré-premier sorti est presque pleine.

3. Circuit selon la revendication 1 ou 2, dans lequel lesdits moyens de détermination comprennent des moyens de comptage (44, 46).

4. Circuit selon la revendication 3, dans lequel lesdits moyens de comptage (44, 46) ont un temps de stabilisation prédéterminé lors de la réalisation d'une transition dudit premier état logique audit second état logique, et dudit second état logique audit premier état logique et dans lequel lesdits moyens de blocage comprennent :
des premiers moyens de blocage (188, BEP) pour empêcher la production dudit signal de mise à un pendant une durée prédéterminée après la réception dudit signal d'Ecriture externe pour permettre auxdits moyens de comptage de se stabiliser de sorte que ladite durée prédéterminée est plus longue que ledit temps de stabilisation ; et
des seconds moyens de blocage (AEP, 214) pour empêcher la production dudit signal de remise à zéro pendant une seconde durée prédéterminée après la réception dudit signal de Lecture externe pour permettre auxdits moyens de comptage de se stabiliser, ladite seconde durée prédéterminée étant plus longue que ledit temps de stabilisation prédéterminé.

5. Circuit selon l'une quelconque des revendications 1 à 4, dans lequel lesdits moyens de mise à un comprennent des moyens (204) pour déterminer si ledit signal de comparaison est présent lorsque ledit signal d'Ecriture externe est reçu et pour produire ledit signal de mise à un en réponse à celui-ci, de sorte que ledit signal de mise à un est produit indépendamment desdits moyens de détermination (44, 46) ayant leur sortie modifiée dudit second état logique audit premier état logique.

6. Circuit selon l'une quelconque des revendications 1 à 5, dans lequel lesdits moyens de détermination comprennent :
un premier dispositif de comptage (46) pour être incrémenté en réponse à la réception dudit signal de Lecture externe et ayant une première valeur de comptage correspondant à la valeur dudit pointeur de Lecture ;
un second dispositif de comptage (44) pour être incrémenté en réponse à la réception dudit signal d'Ecriture externe et ayant une seconde valeur de comptage correspondant à la valeur dudit pointeur d'Ecriture de sorte que la différence de valeur entre lesdites première et seconde valeurs de comptage correspond à la proximité desdits pointeurs de Lecture et d'Ecriture, et
un circuit de comparaison (48) pour comparer ladite première valeur avec la seconde valeur et pour sortir un signal de comparaison dans ledit second état logique lorsque lesdites première et seconde valeurs de comptage ont entre elles ladite différence prédéterminée.

7. Circuit selon l'une quelconque des revendications 1 à 6, dans lequel lesdits moyens de mise à un comprennent :
un circuit à verrouillage (192) ayant une entrée de données (D) connectée à la sortie desdits moyens de détermination et étant fonctionnel pour verrouiller l'état logique sur la sortie desdits moyens de détermination à la sortie (QZ) dudit circuit à verrouillage (192) en réponse à la réception dudit signal d'Ecriture externe ;
une porte ET (204) ayant une première et une seconde entrées et une sortie et étant fonctionnelle pour accomplir une fonction ET logique ; et
des moyens de production d'impulsions (116, 118, 120, 124, 130, 142, 164, 162) pour produire une impulsion d'Ecriture (AEP) ayant une largeur d'impulsion d'une durée prédéterminée et produite en réponse à la réception dudit signal d'Ecriture externe, ladite impulsion d'Ecriture étant entrée dans une entrée de ladite porte ET (204) et ladite impulsion d'Ecriture étant fonctionnelle pour commander ledit circuit à verrouillage (192) pour verrouiller l'état logique de la sortie desdits moyens de détermination dans l'autre entrée de ladite porte ET,
la sortie de ladite porte ET (204) comprenant ledit signal de mise à un qui est produit seulement durant la largeur d'impulsion de ladite impulsion d'Ecriture et en réponse à la sortie desdits moyens de détermination qui est dans le second état logique au début de ladite impulsion d'Ecriture.

8. Circuit selon la revendication 7, dans lequel la production dudit signal de remise à zéro est inhibé lors de ladite impulsion d'Ecriture.

9. Circuit selon l'une des revendications 7 ou 8, dans lequel lesdits moyens de blocage interdisent la production dudit signal de remise à zéro pendant ladite durée prédéterminée.

10. Circuit selon la revendication 6 ou de l'une quelconque des revendications en dépendant, dans lequel ledit circuit de comparaison (48) et lesdits premier et second dispositifs de comptage (44, 46) ont un temps de stabilisation prédéterminé lors de la réalisation d'une transition entre lesdits premier et second états logiques et dans lequel ladite durée prédéterminée desdits moyens de blocage excède ledit temps de stabilisation.

11. Procédé pour indiquer qu'une mémoire de type premier entré-premier sorti (10) est remplie jusqu'à un niveau prédéterminé, comprenant :
la production d'un pointeur de Lecture (28) qui détermine un emplacement dans la mémoire de type premier entré-premier sorti pour y lire des informations, le pointeur de Lecture étant incrémenté pour chaque opération de Lecture en réponse à la réception d'un signal de Lecture externe ;
la production d'un pointeur d'Ecriture (26) qui détermine un emplacement dans la mémoire de type premier entré-premier sorti pour y écrire des informations, le pointeur d'Ecriture étant incrémenté pour chaque opération d'Ecriture en réponse à la réception d'un signal d'Ecriture externe ; et
la détermination de la différence entre les pointeurs de Lecture et d'Ecriture et la commande d'un signal de comparaison pour effectuer un changement d'un premier état logique à un second état logique lorsque la différence est égale à une valeur de proximité prédéterminée représentative de ce que la mémoire de type premier entré-premier sorti est remplie jusqu'audit niveau prédéterminé et pour passer du second état logique au premier état logique lorsque la proximité s'écarte de la valeur de proximité prédéterminée,
caractérisé par les étapes de
production d'un signal de remise à zéro en réponse au signal de comparaison qui est dans le second état logique ;
production d'un signal de mise à un en réponse au signal de comparaison qui est dans le second état logique lorsqu'un signal d'Ecriture externe est reçu ;
blocage de la production du signal de remise à zéro pendant une durée prédéterminée après la réception du signal de Lecture externe pour empêcher le signal de remise à zéro d'être produit lorsque le signal de comparaison effectue une transition du second état logique au premier état logique ; et
positionnement d'un indicateur (HALFZ) dans une condition de mise à un lorsque le signal de mise à un est produit et positionnement de l'indicateur dans une condition de remise à zéro en réponse à la production du signal de remise à zéro.

12. Procédé de la revendication 11, dans lequel l'étape de détermination de la valeur de proximité comprend :
l'incrémentation d'un premier dispositif de comptage (46) en réponse à la réception du signal de Lecture externe, le premier dispositif de comptage ayant une première valeur de comptage correspondant à la valeur du pointeur de Lecture ;
l'incrémentation d'un second dispositif de comptage (44) en réponse à la réception du signal d'Ecriture externe, le second dispositif de comptage ayant une seconde valeur de comptage correspondant à la valeur du pointeur d'Ecriture ; et
la comparaison des première et seconde valeurs de comptage et la sortie du signal de comparaison dans le second état logique lorsque la proximité des pointeurs de Lecture et d'Ecriture est égale à la valeur de proximité prédéterminée.
